# FASCICULE DE BREVET EUROPEEN

(11) **EP 2 851 955 B1**
(45) Date de publication et mention de la délivrance du brevet: **22.06.2022**
(21) Numéro de dépôt: 14184877.0
(22) Date de dépôt: 16.09.2014
(51) Int. Cl.: H01L 27/146

(54) **Procédé de réalisation d'un filtre optique au sein d'un circuit intégré, et circuit intégré correspondant**
Herstellungsverfahren eines optischen Filters innerhalb eines integrierten Schaltkreises, und entsprechender integrierter Schaltkreis
Method for fabricating an optical filter in an integrated circuit, and corresponding integrated circuit

(30) Priorité: 19.09.2013 FR 1359026
(43) Date de publication de la demande: 25.03.2015
(73) Titulaire: STmicroelectronics SA, 92120 Montrouge (FR); STMicroelectronics (Crolles 2) SAS, 38920 Crolles (FR); COMMISSARIAT À L'ÉNERGIE ATOMIQUE ET AUX ÉNERGIES ALTERNATIVES, 75015 Paris (FR)
(72) Inventeur: Marty, Michel, 38760 SAINT PAUL DE VARCES (FR); Jouan, Sebastien, 38920 CROLLES (FR); Frey, Laurent, 38600 FONTAINE (FR)
(74) Mandataire: Casalonga

(56) Documents cités:
- US-A1- 2009 298 220
- US-A1- 2012 267 694

## Description

L'invention concerne les circuits intégrés et notamment ceux de type imageurs, qui comprennent des zones photosensibles.

Les zones photosensibles de circuits intégrés de type imageurs peuvent être des régions de substrat de photodiodes, notamment des photodiodes à avalanche déclenchée par un photon individuel (« SPAD : Single Photon Avalanche DIODE » en langue anglaise).

On utilise notamment ce type de photodiode pour détecter des photons dont la longueur d'onde est située dans l'infrarouge (autour de 850 nm). Cela étant, l'efficacité quantique de ces photodiodes est faible pour ces longueurs d'onde, alors qu'elle est élevée pour les longueurs d'onde du domaine visible. Le rapport signal sur bruit de ces photodiodes peut donc être mauvais.

Il a donc été proposé d'utiliser des filtres pour diminuer la détection des rayonnements du domaine visible qui peuvent être considérés comme du bruit pour le fonctionnement des photodiodes à avalanche déclenchées par un photon individuel. Cela étant, ces filtres ne sont pas toujours suffisamment performants.

Selon un mode de mise en œuvre et de réalisation, il est proposé un procédé de réalisation d'un filtre optique au sein d'un circuit intégré, et un circuit intégré comprenant un filtre optique, qui améliorent le rapport signal sur bruit au sein de zones photosensibles situées dans des substrats, en particulier les zones photosensibles de photodiodes à avalanche déclenchée par un photon individuel.

Selon un aspect, il est proposé un procédé de réalisation d'un filtre optique destiné à filtrer des rayonnements au sein d'un circuit intégré comportant un substrat et une partie d'interconnexion au dessus du substrat.

Selon une caractéristique générale de cet aspect, la réalisation du filtre comprend une formation d'au moins une couche de filtre électriquement conductrice adaptée à être polarisée au-dessus d'une zone photosensible située dans le substrat et entre le substrat et la partie d'interconnexion, ou en dessous de la zone photosensible et à l'opposé de la partie d'interconnexion, le produit entre l'épaisseur de la couche de filtre et la partie imaginaire de l'indice de réfraction de la couche de filtre étant supérieur à 1 nanomètre pour les longueurs d'ondes des rayonnements à filtrer, et on connecte ladite couche de filtre électriquement conductrice à ladite partie d'interconnexion par au moins un contact adaptée à polariser la couche de filtre.

Par filtrer, on entend une réduction du passage des rayonnements qui sont donc bloqués. A titre d'exemple, on peut souhaiter filtrer le rayonnement correspondant au domaine visible pour détecter des rayonnements infrarouges.

Les inventeurs ont en effet observé qu'il était possible de disposer une couche de filtre ayant certaines propriétés optiques (en particulier un produit entre la partie imaginaire de son indice de réfraction et son épaisseur qui a une valeur élevée) directement au dessus de la zone photosensible du substrat, avant la formation de la partie d'interconnexion, ou au dos du substrat, par exemple pour un imageur à illumination par la face arrière.

On peut ainsi bloquer certains rayonnements, en particulier les rayonnements du domaine visible lorsque l'on souhaite détecter des rayonnements infrarouges.

De préférence, le produit entre l'épaisseur de la couche de filtre et la partie imaginaire de l'indice de réfraction peut être supérieur à 10 nanomètres pour les longueurs d'ondes des rayonnements à filtrer.

On peut former une couche de filtre électriquement conductrice et adaptée à être polarisée.

L'invention concerne une couche de filtre conductrice, pour pouvoir polariser cette couche de filtre et améliorer le comportement électrique du dispositif de détection qui comprend la zone photosensible. On pourra notamment ainsi améliorer la diffusion des électrons dans le substrat.

Cette couche de filtre est connectée à ladite partie d'interconnexion par au moins un contact.

La formation de ladite au moins une couche de filtre peut comprendre une formation d'une couche contenant du silicium polycristallin ou encore du silicium amorphe.

La formation de ladite au moins une couche de filtre peut comprendre une formation d'une couche contenant du silicium polycristallin et un dopage de type P de la couche.

Le silicium polycristallin, avec une hauteur suffisante (par exemple 180 nm) et ayant un dopage de type P, a des propriétés optiques satisfaisantes, et peut-être polarisé.

La formation de ladite au moins une couche est effectuée simultanément et au même niveau que la formation d'une région de grille d'un transistor du circuit intégré, la couche de filtre étant réalisée au dessus de la zone photosensible et entre le substrat et la partie d'interconnexion.

Les circuits intégrés comprennent généralement des transistors munis de région de grille en silicium polycristallin dopé, il est donc possible de former la couche de filtre et ces régions de grille simultanément. Selon un aspect, l'invention permet donc d'obtenir une couche de filtre sans aucune étape de fabrication supplémentaire, mais simplement en modifiant les motifs des masques de photolithographie utilisés.

La formation de la zone photosensible peut comprendre la formation d'une photodiode à avalanche déclenchée par un photon individuel.

La réalisation du filtre peut comprendre en outre une formation d'une couche supplémentaire de filtre située au dessus ou à l'intérieur de la partie d'interconnexion si la couche de filtre est réalisée au dessus de la zone photosensible et entre le substrat et la partie d'interconnexion, ou réalisée en dessous de la couche de filtre si la couche de filtre est réalisée en dessous de la zone photosensible et à l'opposée de la partie d'interconnexion.

En effet, on pourra également utiliser un filtre selon l'art antérieur pour compléter le filtrage.

Selon un autre aspect, il est proposé un procédé de réalisation d'un circuit intégré comprenant une réalisation au sein du circuit intégré, d'un filtre optique selon le procédé tel que défini ci-avant.

Selon un autre aspect, il est proposé un circuit intégré comportant un substrat, une partie d'interconnexion au dessus du substrat et un filtre optique destiné à filtrer des rayonnements.

Selon une caractéristique générale de cet autre aspect, le filtre optique comprend au moins une couche de filtre électriquement conductrice et adaptée à être polarisée située au dessus d'une zone photosensible située dans le substrat et entre le substrat et la partie d'interconnexion, ou située en dessous de la zone photosensible et à l'opposé de la partie d'interconnexion, le produit entre l'épaisseur de la couche de filtre et la partie imaginaire de l'indice de réfraction de la couche de filtre étant supérieur à 1 nanomètre pour les longueurs d'ondes des rayonnements à filtrer. Le circuit intégré comprend en outre au moins un contact connectant la couche de filtre électriquement conductrice à ladite partie d'interconnexion et adaptée à polariser la couche de filtre.

Pour filtrer une longueur d'onde de l'ordre de 500 nanomètres (rayonnement visible), on peut utiliser une couche de silicium polycristallin ayant une épaisseur de 180 nanomètres et une valeur de partie imaginaire de l'indice de réfraction égale à 0,14. Le produit de l'épaisseur et de la partie imaginaire est alors égal à 25 nanomètres, ce qui permet de diminuer l'intensité lumineuse à 500 nanomètres d'environ 46%.

Le produit entre l'épaisseur de la couche de filtre et la partie imaginaire de l'indice de réfraction peut être supérieur à 10 nanomètres pour les longueurs d'ondes des rayonnements à filtrer.

La couche de filtre électriquement conductrice peut être connectée à ladite partie d'interconnexion par au moins un contact.

La couche de filtre peut contenir du silicium polycristallin ou du silicium amorphe.

La couche de filtre peut contenir du silicium polycristallin ayant un dopage de type P.

Le circuit intégré peut comprendre en outre au moins un transistor dont la région de grille comprend du silicium polycristallin ayant un dopage de type P et la même épaisseur que la couche de filtre, la couche de filtre et la région de grille étant situées au même niveau, la couche de filtre étant située au dessus de la zone photosensible et entre le substrat et la partie d'interconnexion.

La zone photosensible peut être une zone photosensible de photodiode à avalanche déclenchée par un photon individuel.

Le circuit intégré peut comprendre en outre une couche supplémentaire de filtre située au dessus ou à l'intérieur de la partie d'interconnexion si la couche de filtre est située au dessus de la zone photosensible et entre le substrat et la partie d'interconnexion, ou située en dessous de la couche de filtre si la couche de filtre est située en dessous de la zone photosensible et à l'opposé de la partie d'interconnexion.

D'autres avantages et caractéristiques de l'invention apparaîtront à l'étude de la description détaillée de modes de mise en œuvre et de réalisation, pris à titre d'exemple non limitatifs et illustrés par les dessins annexés sur lesquels :

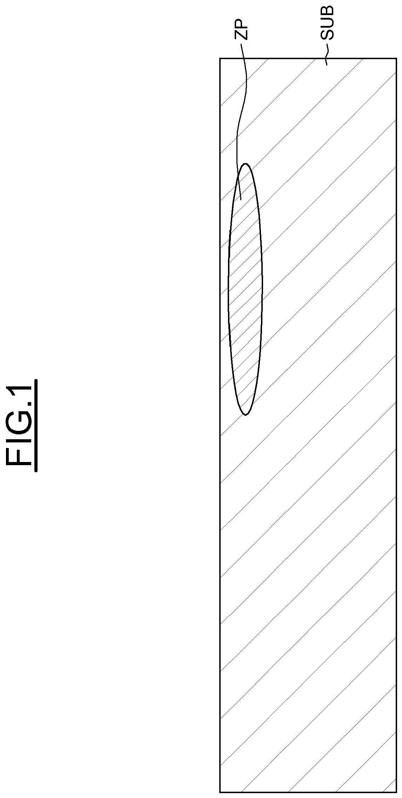

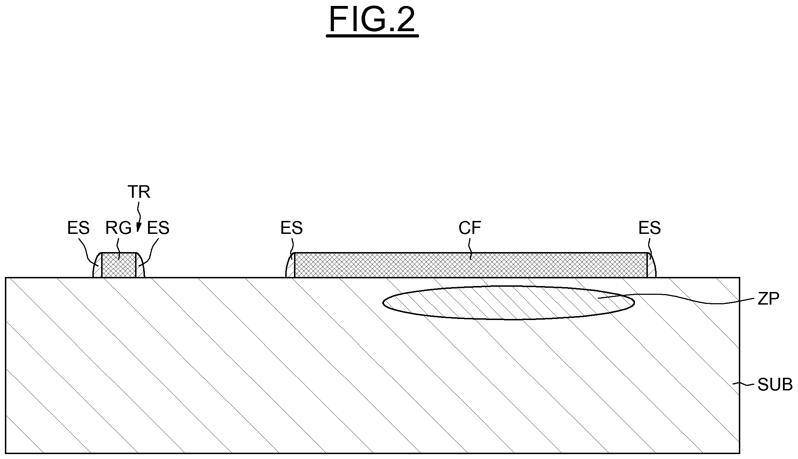

- les figures 1 à 4 illustrent différentes étapes d'un mode de mise en œuvre d'un procédé selon l'invention.

Sur la figure 1, on a représenté un substrat SUB, par exemple en silicium, dans lequel on a déjà formé une zone photosensible ZP.

La zone photosensible ZP peut faire partie d'une photodiode à avalanche déclenchée par un photon individuel, ou encore d'une photodiode désignée sous l'expression anglo-saxonne « pinned diode ».

À titre indicatif, la zone photosensible ZP peut-être destinée à détecter des photons ayant une longueur d'onde située dans l'infrarouge, et il est donc préférable de bloquer les rayonnements du domaine visible pour qu'ils n'atteignent pas cette zone photosensible.

Il convient de noter que la zone ZP est une zone photosensible d'imageur dit « face avant ». En variante, il est possible de mettre en œuvre l'invention au sein d'un imageur à illumination face arrière

Pour bloquer ces rayonnements, on peut former une couche de filtre CF au dessus de la zone photosensible ZP.

Cette couche de filtre CF peut être une couche en silicium polycristallin ayant un dopage de type P. Simultanément, on peut également avoir formé une région de grille RG de transistor TR sur le substrat SUB. De ce fait, la formation de la couche de filtre peut comprendre les mêmes étapes que la formation d'une grille de transistor. Généralement, les grilles de transistor ont des épaisseurs de l'ordre de 180 nm, et cette épaisseur permet d'obtenir une couche de filtre adapté pour filtrer les rayonnements du domaine visible. Le produit entre l'épaisseur de la couche de filtre et la partie imaginaire de l'indice de réfraction de cette couche de filtre est ici supérieur à 1 nanomètre voire à 10 nanomètres pour les longueurs d'ondes des rayonnements à bloquer, ce qui correspond à une bonne absorption.

A titre d'exemple, pour une épaisseur de silicium polycristallin de 180 nanomètres, (avec une partie imaginaire de l'indice de réfraction égale à 0.054 pour la longueur d'onde de 600 nm), on a un produit (domaine visible à filtrer) de l'ordre de 9.7 nanomètres, ce qui correspond à une atténuation de l'intensité lumineuse à 600 nanomètres reçue de l'ordre de 18% environ. Une même couche de silicium polycristallin a, au voisinage d'une longueur d'onde de 850 nanomètres à laisser passer, un produit de l'ordre de 0.7 nanomètres (avec une partie imaginaire de l'indice de réfraction égale à 0.004), ce qui correspond à une atténuation très faible de 1% environ.

Pour une couche de silicium amorphe ayant une épaisseur égale à 180 nanomètres (partie imaginaire de l'indice de réfraction égale à 0.5), on a un produit à 500 nanomètres égal à 90 nanomètres, ce qui correspond à une atténuation de 90% environ.

On peut noter que des espaceurs ES sont formés de part et d'autre de la région de grille RG et également au voisinage des bords de la couche de filtre CF.

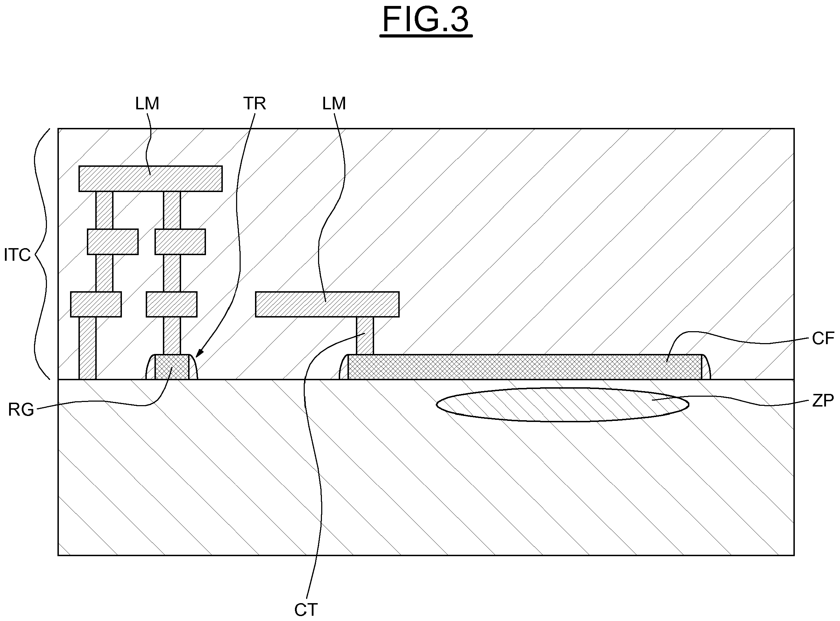

On peut ensuite former une région d'interconnexion ITC au dessus du substrat sur lequel on a formé la couche de filtre CF et le transistor TR, comme illustré sur la figure 3.

La région d'interconnexion ITC (communément désignée par l'homme du métier sous l'acronyme anglo-saxon « BEOL : Back End Of Line ») comprend une pluralité de lignes métalliques LM, mais il est préférable qu'aucune ligne métallique LM ne s'étende au-dessus de la zone photosensible ZP.

La couche de filtre CF s'étend latéralement au-delà de la zone photosensible ZP, et un contact électrique CT a été formé pour connecter cette couche de filtre au réseau d'interconnexion ITC. Avec le contact CT, on peut polariser la couche de filtre CF et ainsi obtenir un fonctionnement amélioré pour la zone photosensible ZP.

En effet en polarisant la couche de filtre CF par un contact électrique, on vient créer un champ électrique qui crée une zone d'accumulation de trous sous l'interface du silicium cristallin. De ce fait on s'affranchit des défauts de surface, ce qui permet de diminuer le « DCR » (« Dark Count Rate ») pour un capteur à photon unique de type SPAD ou le courant d'obscurité pour un imageur, et cela sans dégrader l'efficacité quantique (QE : Quantum Efficiency) des pixels.

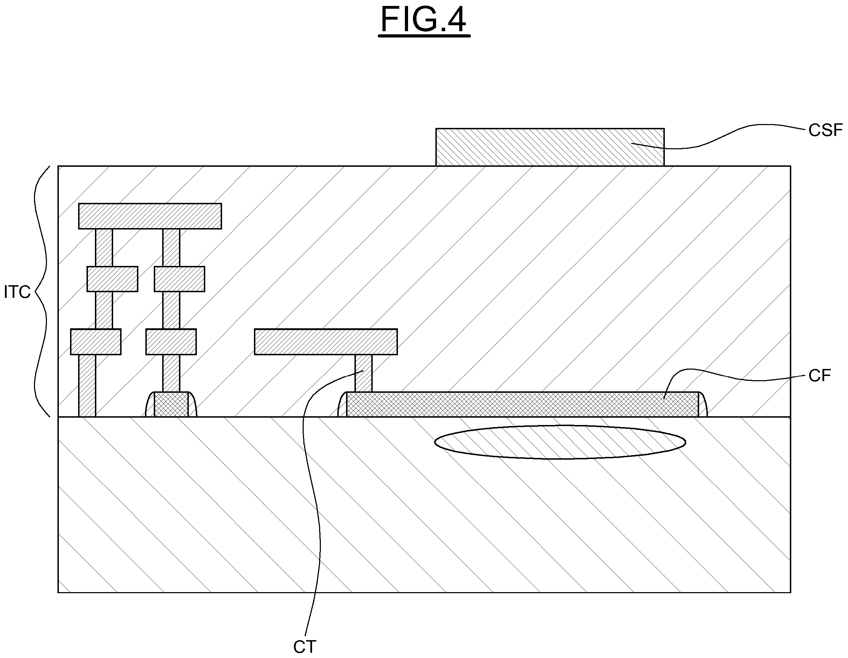

Bien que cela ne soit pas obligatoire, la couche de filtre CF peut-être complétée par une couche supplémentaire de filtre CSF située au-dessus ou à l'intérieur de la partie d'interconnexion ITC, comme illustré sur la figure 4.

La couche supplémentaire de filtre CSF peut être un empilement de filtre optique multicouche, ou encore une couche de résine. Ce filtre optique multicouche peut être un filtre optique multicouche comprenant des couches de métal et des couches de matériau diélectrique. A titre indicatif, pour transmettre une longueur d'onde de 850 nanomètres et bloquer les rayonnements dans le domaine visible, on peut utiliser une couche supplémentaire de filtre comportant deux couches de cuivre ayant une épaisseur d'environ 25 nanomètres séparées par une couche de nitrure de silicium ayant une épaisseur d'environ 180 nanomètres. On pourra également former des couches de nitrure de silicium autour des couches de cuivre pour améliorer l'adhérence des couches de cuivre et les protéger.

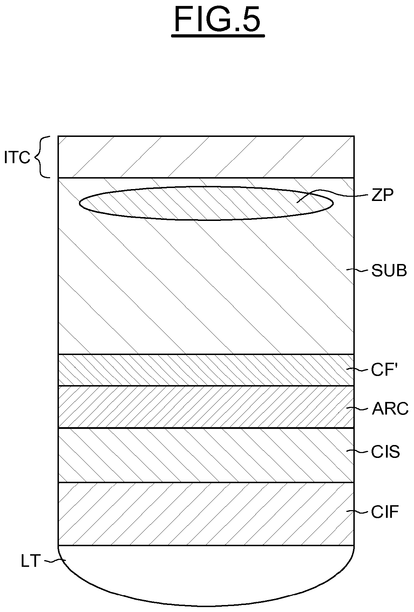

Sur la figure 5, on a représenté une variante de l'invention dans laquelle une couche de filtre CF' est réalisée en dessous d'une zone photosensible ZP d'un substrat SUB et à l'opposé de la partie d'interconnexion ITC. On obtient ainsi un imageur à illumination par la face arrière.

Comme illustré sur la figure 5, la couche de filtre CF' est réalisée sous le substrat SUB. On peut également former, sous la couche de filtre CF', une couche antireflet ARC par exemple en nitrure de silicium, une couche isolante CIS par exemple en dioxyde de silicium et une couche supplémentaire de filtre inférieure CIF, par exemple un filtre optique multicouche. Enfin, on peut réaliser, sous la couche supplémentaire de filtre inférieure, une lentille optique.

On obtient ainsi, avec la couche CF', une bonne atténuation des rayonnements à filtrer. La couche CF' peut être en silicium polycristallin ou préférentiellement en silicium amorphe.

Selon un aspect de l'invention, on obtient un meilleur fonctionnement des circuits intégrés comprenant des zones photosensibles, c'est-à-dire des circuits intégrés imageurs.

Selon un aspect de l'invention, on obtient un filtrage supplémentaire qui ne nécessite aucune étape de fabrication supplémentaire, et qui peut améliorer la diffusion des électrons dans le substrat sous-jacent.

Selon encore un autre aspect de l'invention, on peut filtrer des rayonnements pour les imageurs à illumination face arrière.

## Revendications

1. Procédé de réalisation d'un filtre optique destiné à filtrer des rayonnements au sein d'un circuit intégré comportant un substrat (SUB) et une partie d'interconnexion (ITC) au dessus du substrat, le procédé de réalisation du filtre comprenant une formation d'au moins une couche de filtre électriquement conductrice adaptée à être polarisée (CF) au-dessus d'une zone photosensible (ZP) située dans le substrat et entre le substrat et la partie d'interconnexion, ou en dessous de la zone photosensible et à l'opposé de la partie d'interconnexion, le produit entre l'épaisseur de la couche de filtre (CF) et la partie imaginaire de l'indice de réfraction de la couche de filtre (CF) étant supérieur à 1 nanomètre pour les longueurs d'ondes des rayonnements à filtrer, et le procédé étant **caractérisé en ce qu'**on connecte ladite couche de filtre électriquement conductrice (CF) à ladite partie d'interconnexion (ITC) par au moins un contact pour polariser la couche de filtre (CF).

2. Procédé selon la revendication 1, dans lequel le produit entre l'épaisseur de la couche de filtre et la partie imaginaire de l'indice de réfraction est supérieur à 10 nanomètres pour les longueurs d'onde des rayonnements à filtrer.

3. Procédé selon l'une quelconque des revendications précédentes, dans lequel la formation de ladite au moins une couche de filtre comprend une formation d'une couche contenant du silicium polycristallin ou du silicium amorphe.

4. Procédé selon la revendication 3, dans lequel la formation de ladite au moins une couche de filtre comprend une formation d'une couche contenant du silicium polycristallin et un dopage de type P de la couche.

5. Procédé selon la revendication 3, dans lequel la formation de ladite au moins une couche est effectuée simultanément et au même niveau que la formation d'une région de grille (RG) d'un transistor (TR) du circuit intégré, la couche de filtre étant réalisée au dessus de la zone photosensible et entre le substrat et la partie d'interconnexion.

6. Procédé selon l'une quelconque des revendications précédentes, dans lequel la formation de la zone photosensible comprend la formation d'une photodiode à avalanche déclenchée par un photon individuel.

7. Procédé selon l'une quelconque des revendications précédentes, dans lequel la réalisation du filtre comprend en outre une formation d'une couche supplémentaire de filtre (CSF) située au dessus ou à l'intérieur de la partie d'interconnexion si la couche de filtre est réalisée au dessus de la zone photosensible et entre le substrat et la partie d'interconnexion, ou réalisée en dessous de la couche de filtre si la couche de filtre est réalisée en dessous de la zone photosensible et à l'opposé de la partie d'interconnexion.

8. Procédé de réalisation d'un circuit intégré comprenant une réalisation au sein du circuit intégré, d'un filtre optique selon le procédé selon l'une des revendications 1 à 7.

9. Circuit intégré comportant un substrat (SUB), une partie d'interconnexion (ITC) au dessus du substrat et un filtre optique destiné à filtrer des rayonnements, le filtre optique comprenant au moins une couche de filtre électriquement conductrice adaptée à être polarisée (CF) située au dessus d'une zone photosensible (ZP) située dans le substrat et entre le substrat et la partie d'interconnexion, ou située en dessous de la zone photosensible et à l'opposé de la partie d'interconnexion, le produit entre l'épaisseur de la couche de filtre et la partie imaginaire de l'indice de réfraction de la couche de filtre étant supérieur à 1 nanomètre pour les longueurs d'ondes des rayonnements à filtrer, le circuit intégré étant **caractérisé en ce qu'**il comprend au moins un contact connectant la couche de filtre électriquement conductrice (CF) à ladite partie d'interconnexion (ITC) pour polariser la couche de filtre (CF).

10. Circuit intégré selon la revendication 9, dans lequel le produit entre l'épaisseur de la couche de filtre et la partie imaginaire de l'indice de réfraction est supérieur à 10 nanomètres pour les longueurs d'ondes des rayonnements à filtrer.

11. Circuit intégré selon l'une quelconque des revendications 9 ou 10, dans lequel la couche de filtre contient du silicium polycristallin ou du silicium amorphe.

12. Circuit intégré selon la revendication 11, dans lequel la couche de filtre contient du silicium polycristallin ayant un dopage de type P.

13. Circuit intégré selon la revendication 12, comprenant en outre au moins un transistor (TR) dont la région de grille (RG) comprend du silicium polycristallin ayant un dopage de type P et la même épaisseur que la couche de filtre, la couche de filtre et la région de grille étant situées au même niveau, la couche de filtre étant située au dessus de la zone photosensible et entre le substrat et la partie d'interconnexion.

14. Circuit intégré selon l'une quelconque des revendications 9 à 13, dans lequel la zone photosensible est une zone photosensible de photodiode à avalanche déclenchée par un photon individuel.

15. Circuit intégré selon l'une quelconque des revendications 9 à 14, comprenant en outre une couche supplémentaire de filtre (CSF) située au dessus ou à l'intérieur de la partie d'interconnexion si la couche de filtre est située au dessus de la zone photosensible et entre le substrat et la partie d'interconnexion, ou située en dessous de la couche de filtre si la couche de filtre est située en dessous de la zone photosensible et à l'opposé de la partie d'interconnexion.

## Patentansprüche

1. Verfahren zur Herstellung eines optischen Filters, der dazu bestimmt ist, Strahlungen innerhalb einer integrierten Schaltung, die ein Substrat (SUB) und einen Verbindungsteil (ITC) oberhalb des Substrats umfasst, zu filtern, wobei das Verfahren zur Herstellung des Filters ein Bilden mindestens einer elektrisch leitenden Filterschicht, die dazu geeignet ist, polarisiert zu werden (CF), oberhalb einer lichtempfindlichen Zone (ZP), die im Substrat und zwischen dem Substrat und dem Verbindungsteil liegt, oder unterhalb der lichtempfindlichen Zone und dem Verbindungsteil gegenüberliegend umfasst, wobei das Produkt aus der Dicke der Filterschicht (CF) und dem Imaginärteil des Brechungsindexes der Filterschicht (CF) bei den Wellenlängen der zu filternden Strahlungen größer als 1 Nanometer ist, und das Verfahren **dadurch gekennzeichnet ist, dass** die elektrisch leitende Filterschicht (CF) durch mindestens einen Kontakt mit dem Verbindungsteil (ITC) verbunden wird, um die Filterschicht (CF) zu polarisieren.

2. Verfahren nach Anspruch 1, wobei das Produkt aus der Dicke der Filterschicht und dem Imaginärteil des Brechungsindexes bei den Wellenlängen der zu filternden Strahlungen größer als 10 Nanometer ist.

3. Verfahren nach einem der vorstehenden Ansprüche, wobei das Bilden der mindestens einen Filterschicht ein Bilden einer Schicht umfasst, die polykristallines Silicium oder amorphes Silicium enthält.

4. Verfahren nach Anspruch 3, wobei das Bilden der mindestens einen Filterschicht ein Bilden einer Schicht, die polykristallines Silicium enthält, und ein p-Dotieren der Schicht umfasst.

5. Verfahren nach Anspruch 3, wobei das Bilden der mindestens einen Schicht gleichzeitig und auf gleicher Höhe erfolgt wie das Bilden einer Gate-Region (RG) eines Transistors (TR) der integrierten Schaltung, wobei die Filterschicht oberhalb der lichtempfindlichen Zone und zwischen dem Substrat und dem Verbindungsteil hergestellt wird.

6. Verfahren nach einem der vorstehenden Ansprüche, wobei das Bilden der lichtempfindlichen Zone das Bilden einer Lawinenphotodiode umfasst, die durch ein einzelnes Photon ausgelöst wird.

7. Verfahren nach einem der vorstehenden Ansprüche, wobei das Herstellen des Filters weiter ein Bilden einer zusätzlichen Filterschicht (CSF) umfasst, die oberhalb oder im Inneren des Verbindungsteils liegt, wenn die Filterschicht oberhalb der lichtempfindlichen Zone und zwischen dem Substrat und dem Verbindungsteil hergestellt wird, oder unterhalb der Filterschicht hergestellt wird, wenn die Filterschicht unterhalb der lichtempfindlichen Zone und dem Verbindungsteil gegenüberliegend hergestellt wird.

8. Verfahren zur Herstellung einer integrierten Schaltung, das ein Herstellen eines optischen Filters nach dem Verfahren nach einem der Ansprüche 1 bis 7 innerhalb der integrierten Schaltung umfasst.

9. Integrierte Schaltung, die ein Substrat (SUB), einen Verbindungsteil (ITC) oberhalb des Substrats, und einen optischen Filter umfasst, der dazu bestimmt ist, Strahlungen zu filtern, wobei der optische Filter mindestens eine elektrisch leitende Filterschicht umfasst, die dazu geeignet ist, polarisiert zu werden (CF) und die oberhalb einer lichtempfindlichen Zone (ZP) liegt, welche im Substrat und zwischen dem Substrat und dem Verbindungsteil liegt, oder unterhalb der lichtempfindlichen Zone und dem Verbindungsteil gegenüber liegt, wobei das Produkt aus der Dicke der Filterschicht und dem Imaginärteil des Brechungsindexes der Filterschicht bei den Wellenlängen der zu filternden Strahlungen größer als 1 Nanometer ist, wobei die integrierte Schaltung **dadurch gekennzeichnet ist, dass** sie mindestens einen Kontakt umfasst, der die elektrisch leitende Filterschicht (CF) mit dem Verbindungsteil (ITC) verbindet, um die Filterschicht (CF) zu polarisieren.

10. Integrierte Schaltung nach Anspruch 9, wobei das Produkt aus der Dicke der Filterschicht und dem Imaginärteil des Brechungsindexes bei den Wellenlängen der zu filternden Strahlungen größer als 10 Nanometer ist.

11. Integrierte Schaltung nach einem der Ansprüche 9 oder 10, wobei die Filterschicht polykristallines Silicium oder amorphes Silicium enthält.

12. Integrierte Schaltung nach Anspruch 11, wobei die Filterschicht polykristallines Silicium mit einer p-Dotierung enthält.

13. Integrierte Schaltung nach Anspruch 12, die weiter mindestens einen Transistor (TR) umfasst, dessen Gate-Region (RG) polykristallines Silicium mit einer p-Dotierung umfasst und die gleiche Dicke aufweist wie die Filterschicht, wobei die Filterschicht und die Gate-Region auf gleicher Höhe liegen, wobei die Filterschicht oberhalb der lichtempfindlichen Zone und zwischen dem Substrat und dem Verbindungsteil liegt.

14. Integrierte Schaltung nach einem der Ansprüche 9 bis 13, wobei es sich bei der lichtempfindlichen Zone um eine lichtempfindliche Zone einer Lawinenphotodiode handelt, die durch ein einzelnes Photon ausgelöst wird.

15. Integrierte Schaltung nach einem der Ansprüche 9 bis 14, die weiter eine zusätzliche Filterschicht (CSF) umfasst, die oberhalb oder im Inneren des Verbindungsteils liegt, wenn die Filterschicht oberhalb der lichtempfindlichen Zone und zwischen dem Substrat und dem Verbindungsteil liegt, oder unterhalb der Filterschicht liegt, wenn die Filterschicht unterhalb der lichtempfindlichen Zone und dem Verbindungsteil gegenüber liegt.

## Claims

1. A method for producing an optical filter intended to filter radiation within an integrated circuit including a substrate (SUB) and an interconnection portion (ITC) above the substrate, the method for producing the filter comprising a formation of at least one electrically conductive filter layer adapted to be polarised (CF) above a photosensitive area (ZP) located in the substrate and between the substrate and the interconnection portion, or below the photosensitive area and opposite to the interconnection portion, the product between the thickness of the filter layer (CF) and the imaginary portion of the refractive index of the filter layer (CF) being greater than 1 nanometre for the wavelengths of the radiation to be filtered, and the method being **characterised in that** said electrically conductive filter layer (CF) is connected to said interconnection portion (ITC) by at least one contact in order to polarise the filter layer (CF).

2. The method according to claim 1, wherein the product between the thickness of the filter layer and the imaginary portion of the refractive index is greater than 10 nanometres for the wavelengths of the radiation to be filtered,.

3. The method according to any one of the preceding claims, wherein the formation of said at least one filter layer comprises a formation of a layer containing polycrystalline silicon or amorphous silicon.

4. The method according to claim 3, wherein the formation of said at least one filter layer comprises a formation of a layer containing polycrystalline silicon and a P-type doping of the layer.

5. The method according to claim 3, wherein the formation of said at least one layer is performed simultaneously and at the same level as the formation of a gate region (RG) of a transistor (TR) of the integrated circuit, the filter layer being made above the photosensitive area and between the substrate and the interconnection portion.

6. The method according to any one of the preceding claims, wherein the formation of the photosensitive area comprises the formation of a single-photon triggered avalanche photodiode.

7. The method according to any one of the preceding claims, wherein producing the filter further comprises a formation of an additional filter layer (CSF) located above or inside the interconnection portion if the filter layer is made above the photosensitive area and between the substrate and the interconnection portion, or made below the filter layer if the filter layer is made below the photosensitive area and opposite to the interconnection portion.

8. A method for producing an integrated circuit comprising a production, within the integrated circuit, of an optical filter according to the method according to one of claims 1 to 7.

9. An integrated circuit including a substrate (SUB), an interconnection portion (ITC) above the substrate and an optical filter intended to filter radiation, the optical filter comprising at least one electrically conductive filter layer adapted to be polarised (CF), located above a photosensitive area (ZP) located in the substrate and between the substrate and the interconnection portion, or located below the photosensitive area and opposite to the interconnection portion, the product between the thickness of the filter layer and the imaginary portion of the refractive index of the filter layer being greater than 1 nanometre for the wavelengths of the radiation to be filtered, the integrated circuit being **characterised in that** it comprises at least one contact connecting the electrically conductive filter layer (CF) to said interconnection portion (ITC) in order to polarise filter layer (CF).

10. The integrated circuit according to claim 9, wherein the product between the thickness of the filter layer and the imaginary portion of the refractive index is greater than 10 nanometres for the wavelengths of the radiation to be filtered.

11. The integrated circuit according to any one of claims 9 or 10, wherein the filter layer contains polycrystalline silicon or amorphous silicon.

12. The integrated circuit according to claim 11, wherein the filter layer contains polycrystalline silicon having a P-type doping.

13. The integrated circuit according to claim 12, further comprising at least one transistor (TR) whose gate region (RG) comprises polycrystalline silicon having a P-type doping and the same thickness as the filter layer, the filter layer and the gate region being located at the same level, the filter layer being located above the photosensitive area and between the substrate and the interconnection portion.

14. The integrated circuit according to any one of claims 9 to 13, wherein the photosensitive area is a photosensitive area of a single-photon triggered avalanche photodiode.

15. The integrated circuit according to any one of claims 9 to 14, further comprising an additional filter layer (CSF) located above or inside the interconnection portion if the filter layer is located above the photosensitive area and between the substrate and the interconnection portion, or located below the filter layer if the filter layer is located below the photosensitive area and opposite to the interconnection portion.
